# EUROPEAN PATENT APPLICATION

(11) **EP 4 679 501 A1**
(43) Date of publication of application: **14.01.2026**
(21) Application number: 24773998.0
(22) Date of filing: 14.03.2024
(51) Int. Cl.: H01L 23/31

(54) **CHIP, CHIP STACK STRUCTURE, CHIP PACKAGING STRUCTURE, AND ELECTRONIC DEVICE**

(30) Priority: 23.03.2023 CN 202310332340
(71) Applicant: Huawei Technologies Co., Ltd., Shenzhen, Guangdong 518129 (CN)
(72) Inventor: ZHAO, Yanchong, Shenzhen, Guangdong 518129 (CN); BAI, Xiaoyang, Shenzhen, Guangdong 518129 (CN); DONG, Jinwen, Shenzhen, Guangdong 518129 (CN)
(74) Representative: Körber, Martin Hans
(86) International application number: PCT/CN2024/081636
(87) International publication number: WO 2024/193432

(57) **Abstract**

Embodiments of this application provide a chip, a chip stacked structure, a chip package structure, and an electronic device, and relate to the field of semiconductor technologies. The chip is bonded with another chip via a dielectric layer and a plurality of bonding devices that penetrate the dielectric layer, and implements signal interworking. Parasitic capacitance generated between two adjacent bonding devices of the chip is small, so that signal transmission performance of the chip is improved. The chip includes: a die; and a first dielectric layer disposed on a side of the die, and a plurality of bonding devices that penetrate the first dielectric layer. The plurality of bonding devices include a first bonding device and a second bonding device that are adjacent to each other, a channel between the first bonding device and the second bonding device is formed at the first dielectric layer, and a dielectric constant of the channel is less than a dielectric constant of a material of the first dielectric layer.

## Description

This application claims priority to Chinese Patent Application No. 202310332340.3, filed with the China National Intellectual Property Administration on March 23, 2023 and entitled "CHIP, CHIP STACKED STRUCTURE, CHIP PACKAGE STRUCTURE, AND ELECTRONIC DEVICE", which is incorporated herein by reference in its entirety.

### TECHNICAL FIELD

This application relates to the field of semiconductor technologies, and in particular, to a chip, a chip stacked structure, a chip package structure, and an electronic device.

### BACKGROUND

Currently, an electronic device is developing towards a trend of a smaller size and a stronger function, and the size of the electronic device depends on a size of a chip in the electronic device. In recent years, a planar size of a chip has been reduced to a limit. A three-dimensional (three dimensional, 3D) stacked packaging technology provides a new solution for reducing a size of a chip. A chip stacked structure may be constructed by using the 3D stacked packaging technology, to further reduce the planar size of the chip.

The chip stacked structure includes two or more chips that are vertically stacked. In the chip stacked structure, two adjacent chips are stacked via respective dielectric layers and a plurality of bonding devices that penetrate the dielectric layers. Specifically, a plurality of bonding devices of one chip may be electrically connected to a plurality of bonding devices of the other chip to implement stacking. In the two or more vertically stacked chips, a distance between two adjacent bonding devices of any chip is referred to as an interconnection spacing. To enable the chip stacked structure to feature high bandwidth and low power consumption, the interconnection spacing of the chip is continuously reduced, to continuously increase interconnection density.

However, with the reduction of the interconnection spacing, parasitic capacitance generated between the two adjacent bonding devices has increasingly greater impact on the chip. The parasitic capacitance increases a resistive-capacitive delay (resistive-capacitive delay, RC delay) of the chip, which reduces signal transmission performance of the chip.

### SUMMARY

Embodiments of this application provide a chip, a chip stacked structure, a chip package structure, and an electronic device. Parasitic capacitance generated between two adjacent bonding devices of the chip is small, so that signal transmission performance of the chip is improved.

According to a first aspect, a chip is provided, including: a die; and a first dielectric layer disposed on a side of the die, and a plurality of bonding devices that penetrate the first dielectric layer. The plurality of bonding devices include a first bonding device and a second bonding device that are adjacent to each other, a channel between the first bonding device and the second bonding device is formed at the first dielectric layer, and a dielectric constant of the channel is less than a dielectric constant of a material of the first dielectric layer. In the chip, the chip is bonded with another chip via the first dielectric layer and the plurality of bonding devices that penetrate the first dielectric layer. For example, the first bonding device of the chip is electrically connected to a bonding device of the another chip; the second bonding device of the chip is electrically connected to a bonding device of the another chip; and the first dielectric layer of the chip is fused with a dielectric layer of the another chip, or the first dielectric layer of the chip is in contact with a dielectric layer of the another chip. When the chip is bonded with the another chip and signal interworking is implemented, a signal passes through the first bonding device, a signal passes through the second bonding device, and the channel between the first bonding device and the second bonding device is formed at the first dielectric layer. The first bonding device, the second bonding device, and the first dielectric layer and the channel between the first bonding device and the second bonding device form a first capacitor. One electrode of the first capacitor is the first bonding device and the other electrode of the first capacitor is the second bonding device, and a dielectric material of the first capacitor includes the first dielectric layer and the channel. Because the dielectric constant of the channel is less than the dielectric constant of the material of the first dielectric layer, a dielectric constant of the combination of the first dielectric layer and the channel is less than the dielectric constant of the first dielectric layer, so that a capacitance value of the first capacitor is less than a capacitance value between two existing adjacent bonding devices. When the capacitance value of the first capacitor is small, a delay of the signal transmitted via the first bonding device is reduced, and a delay of the signal transmitted via the second bonding device is also reduced, so that a resistive-capacitive delay (resistive-capacitive delay, RC delay) of the chip is reduced, and signal transmission performance of the chip is improved.

Optionally, the channel is filled with air or an inert gas; or the channel is of a vacuum environment; or the channel is filled with a predetermined material, and a dielectric constant of the predetermined material is less than the dielectric constant of the material of the first dielectric layer.

Optionally, a first channel surrounding the first bonding device is formed at the first dielectric layer, and the channel includes a part that is of the first channel and that is located between the first bonding device and the second bonding device. In this optional manner, a top view shape of the first channel may be a circular ring, a rectangular ring, or a polygonal ring. The first bonding device is located in a first direction of the second bonding device, and the part that is of the first channel and that is located between the first bonding device and the second bonding device can reduce parasitic capacitance between the first bonding device and the second bonding device. When a predetermined bonding device is located in a second direction of the first bonding device, a part that is of the first channel and that is located in the second direction of the first bonding device can reduce parasitic capacitance between the predetermined bonding device and the first bonding device; and/or when the predetermined bonding device is located in a third direction of the first bonding device, a part that is of the first channel and that is located in the third direction of the first bonding device can reduce the parasitic capacitance between the predetermined bonding device and the first bonding device; and/or when the predetermined bonding device is located in a fourth direction of the first bonding device, a part of an area that is of the first channel and that is located in the fourth direction of the first bonding device can reduce the parasitic capacitance between the predetermined bonding device and the first bonding device.

Optionally, the first channel surrounding the first bonding device is formed at the first dielectric layer, the first channel includes a plurality of spaced subchannels, and the channel includes a part of subchannels that are of the first channel and that are located between the first bonding device and the second bonding device. In this optional manner, the first bonding device is located in the first direction of the second bonding device, and the part of subchannels that are of the first channel and that are located between the first bonding device and the second bonding device can reduce the parasitic capacitance between the first bonding device and the second bonding device. When the predetermined bonding device is located in the second direction of the first bonding device, a part of subchannels that are of the first channel and that are located in the second direction of the first bonding device can reduce the parasitic capacitance between the predetermined bonding device and the first bonding device; and/or when the predetermined bonding device is located in the third direction of the first bonding device, a part of subchannels that are of the first channel and that are located in the third direction of the first bonding device can reduce the parasitic capacitance between the predetermined bonding device and the first bonding device; and/or when the predetermined bonding device is located in the fourth direction of the first bonding device, a part of subchannels that are of the first channel and that are located in the fourth direction of the first bonding device can reduce the parasitic capacitance between the predetermined bonding device and the first bonding device.

Optionally, a second channel surrounding the second bonding device is formed at the first dielectric layer, and the channel includes a part that is of the second channel and that is located between the first bonding device and the second bonding device. In this optional manner, a top view shape of the second channel may be a circular ring, a rectangular ring, or a polygonal ring. The first bonding device is located in the first direction of the second bonding device, and the part that is of the second channel and that is located between the first bonding device and the second bonding device can reduce the parasitic capacitance between the first bonding device and the second bonding device. When the predetermined bonding device is located in a second direction of the second bonding device, a part that is of the second channel and that is located in the second direction of the second bonding device can reduce parasitic capacitance between the predetermined bonding device and the second bonding device; and/or when the predetermined bonding device is located in a third direction of the second bonding device, a part of an area that is of the second channel and that is located in the third direction of the second bonding device can reduce the parasitic capacitance between the predetermined bonding device and the second bonding device; and/or when the predetermined bonding device is located in a fourth direction of the second bonding device, a part of an area that is of the second channel and that is located in the fourth direction of the second bonding device can reduce the parasitic capacitance between the predetermined bonding device and the second bonding device.

Optionally, the second channel surrounding the second bonding device is formed at the first dielectric layer, the second channel includes a plurality of spaced subchannels, and the channel includes a part of subchannels that are of the second channel and that are located between the first bonding device and the second bonding device. In this optional manner, the first bonding device is located in the first direction of the second bonding device, and the part of subchannels that are of the second channel and that are located between the first bonding device and the second bonding device can reduce the parasitic capacitance between the first bonding device and the second bonding device. When the predetermined bonding device is located in the second direction of the second bonding device, a part of subchannels that are of the second channel and that are located in the second direction of the second bonding device can reduce the parasitic capacitance between the predetermined bonding device and the second bonding device; and/or when the predetermined bonding device is located in the third direction of the second bonding device, a part of subchannels that are of the second channel and that are located in the third direction of the second bonding device can reduce the parasitic capacitance between the predetermined bonding device and the second bonding device; and/or when the predetermined bonding device is located in the fourth direction of the second bonding device, a part of subchannels that are of the second channel and that are located in the fourth direction of the second bonding device can reduce the parasitic capacitance between the predetermined bonding device and the second bonding device.

Optionally, the plurality of bonding devices further include a third bonding device and a fourth bonding device that are adjacent to each other. In this optional manner, another bonding device is further disposed at a bonding layer. The first bonding device is adjacent to the second bonding device in a first direction, and the third bonding device is adjacent to the fourth bonding device in the first direction. Alternatively, the third bonding device is adjacent to the fourth bonding device in a second direction, and the first direction crosses the second direction.

Optionally, a second dielectric layer is further disposed between the die and the first dielectric layer, a first metal routing is disposed at the second dielectric layer, the first metal routing is electrically connected to the first bonding device, and the first metal routing is electrically connected to the second bonding device.

Optionally, a second dielectric layer is further disposed between the die and the first dielectric layer, a first metal routing and a second metal routing are disposed at the second dielectric layer, the first metal routing is electrically connected to the first bonding device, and the second metal routing is electrically connected to the second bonding device.

Optionally, the material of the first dielectric layer includes one or more of the following: silicon oxide, silicon nitride, silicon oxynitride, and nitrogen-doped silicon carbide.

Optionally, materials of the plurality of bonding devices include one or more of the following: copper and tungsten.

According to a second aspect, a chip stacked structure is provided. The chip stacked structure includes a plurality of stacked chips, and the plurality of stacked chips include the chip according to any one of the implementations of the first aspect.

Optionally, the plurality of stacked chips include a first chip and a second chip, the first chip includes the chip according to any one of the implementations of the first aspect, and the second chip includes the chip according to any one of the implementations of the first aspect. A first bonding device of the first chip is electrically connected to a first bonding device of the second chip, a second bonding device of the first chip is electrically connected to a second bonding device of the second chip, and a channel of the first chip is aligned with a channel of the second chip.

According to a third aspect, a chip package structure is provided, including a package substrate and the chip stacked structure according to any one of the implementations of the second aspect. The chip stacked structure is electrically connected to the package substrate.

According to a fourth aspect, an electronic device is provided, including a printed circuit board and the chip package structure according to the third aspect. A package substrate in the chip package structure is electrically connected to the printed circuit board.

According to a fifth aspect, a manufacturing method for a chip is provided, including: forming a first dielectric layer on a side of a die; forming, at the first dielectric layer, a plurality of bonding devices that penetrate the first dielectric layer, where the plurality of bonding devices include a first bonding device and a second bonding device that are adjacent to each other; and forming a channel at the first dielectric layer, where the channel is located between the first bonding device and the second bonding device, and a dielectric constant of the channel is less than a dielectric constant of a material of the first dielectric layer.

Optionally, the channel is filled with air or an inert gas; or the channel is of a vacuum environment; or the channel is filled with a predetermined material, and a dielectric constant of the predetermined material is less than the dielectric constant of the material of the first dielectric layer.

Optionally, forming the channel at the first dielectric layer includes: forming a first channel surrounding the first bonding device at the first dielectric layer. The channel includes a part that is of the first channel and that is located between the first bonding device and the second bonding device.

Optionally, forming the channel at the first dielectric layer includes: forming the first channel surrounding the first bonding device at the first dielectric layer. The first channel includes a plurality of spaced subchannels, and the channel includes a part of subchannels that are of the first channel and that are located between the first bonding device and the second bonding device.

Optionally, forming the channel at the first dielectric layer includes: forming a second channel surrounding the second bonding device at the first dielectric layer. The channel includes a part that is of the second channel and that is located between the first bonding device and the second bonding device.

Optionally, forming the channel at the first dielectric layer includes: forming the second channel surrounding the second bonding device at the first dielectric layer. The second channel includes a plurality of spaced subchannels, and the channel includes a part of subchannels that are of the second channel and that are located between the first bonding device and the second bonding device.

Optionally, forming the channel at the first dielectric layer includes: depositing a protective film, where the protective film covers the first dielectric layer and the plurality of bonding devices; forming a photoresist covering the protective film; performing photoetching on the photoresist to form a channel pattern; and etching the first dielectric layer based on the channel pattern to form the channel.

Optionally, before forming the first dielectric layer on the side of the die, the method further includes: forming a second dielectric layer on the side of the die, where the second dielectric layer is located between the die and the first dielectric layer; and forming a first metal routing at the second dielectric layer, where the first metal routing is electrically connected to the first bonding device, and the first metal routing is electrically connected to the second bonding device.

Optionally, before forming the first dielectric layer on the side of the die, the method further includes: forming the second dielectric layer on the side of the die, where the second dielectric layer is located between the die and the first dielectric layer; and forming the first metal routing and a second metal routing at the second dielectric layer, where the first metal routing is electrically connected to the first bonding device, and the second metal routing is electrically connected to the second bonding device.

According to a sixth aspect, a manufacturing method for a chip stacked structure is provided, including: forming a first chip, where the first chip includes the chip according to any one of the implementations of the first aspect; forming a second chip, where the second chip includes the chip according to any one of the implementations of the first aspect; and bonding the first chip with the second chip, where a first bonding device of the first chip is electrically connected to a first bonding device of the second chip, a second bonding device of the first chip is electrically connected to a second bonding device of the second chip, and a channel of the first chip is aligned with a channel of the second chip.

For technical effect achieved by any one of the possible implementations of the second aspect to the sixth aspect, refer to technical effect achieved by different implementations of the first aspect. Details are not described herein again.

### BRIEF DESCRIPTION OF DRAWINGS

FIG. 1 is a diagram of a structure of an electronic device according to an embodiment of this application;
FIG. 2 is a diagram of a structure of a chip package structure according to an embodiment of this application;
FIG. 3 is a diagram of a structure of a chip stacked structure according to an embodiment of this application;
FIG. 4 is a diagram of a structure of a chip according to an embodiment of this application;
FIG. 5 is a diagram of a structure of a chip according to another embodiment of this application;
FIG. 6 is a sectional view of FIG. 3 along AA';
FIG. 7 is a top view of a chip according to still another embodiment of this application;
FIG. 8 is a sectional view of FIG. 7 along BB';
FIG. 9 is a top view of a chip according to yet another embodiment of this application;
FIG. 10 is a top view of a chip according to another embodiment of this application;
FIG. 11 is a top view of a chip according to still another embodiment of this application;
FIG. 12 is a sectional view of FIG. 11 along BB';
FIG. 13 is a top view of a chip according to yet another embodiment of this application;
FIG. 14 is a top view of a chip according to another embodiment of this application;
FIG. 15 is a top view of a chip according to still another embodiment of this application;
FIG. 16 is a diagram of a structure of a chip stacked structure according to another embodiment of this application;
FIG. 17 is a flowchart of a manufacturing method for a chip according to an embodiment of this application;
FIG. 18 is a diagram 1 of a structure of a chip in a manufacturing method for a chip according to an embodiment of this application;
FIG. 19 is a diagram 2 of a structure of a chip in a manufacturing method for a chip according to an embodiment of this application;
FIG. 20 is a diagram 3 of a structure of a chip in a manufacturing method for a chip according to an embodiment of this application;
FIG. 21 is a diagram 4 of a structure of a chip in a manufacturing method for a chip according to an embodiment of this application;
FIG. 22 is a diagram 5 of a structure of a chip in a manufacturing method for a chip according to an embodiment of this application; and
FIG. 23 is a diagram 6 of a structure of a chip in a manufacturing method for a chip according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Unless defined otherwise, all technical and scientific terms used herein have the same meaning as commonly understood by a person of ordinary skill in the art to which this disclosure belongs. In embodiments of this application, "at least one" means one or more, and "a plurality of" means two or more. "And/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated objects. "At least one of the following items (pieces)" or a similar expression thereof refers to any combination of these items, including a single item (piece) or any combination of a plurality of items (pieces). For example, at least one item (piece) of a, b, or c may represent: a, b, c, a and b, a and c, b and c, or a, b, and c, where a, b, and c may be singular or plural. In addition, in embodiments of this application, the terms such as "first" and "second" do not limit a quantity or an execution sequence.

In addition, in embodiments of this application, position terms such as "top" and "bottom" are defined relative to positions of components in the accompanying drawings. It should be understood that these position terms are relative concepts used for relative description and clarification, and may correspondingly change based on changes in the positions of the components in the accompanying drawings.

In embodiments of this application, the terms such as "example" or "for example" are used to represent giving an example, an illustration, or a description. Any embodiment or design scheme described as "example" or "for example" in embodiments of this application shall not be construed as being more preferred or having more advantages than another embodiment or design scheme. Exactly, use of the word like "example" or "for example" is intended to present a related concept in a specific manner.

The following describes technical solutions of embodiments in this application with reference to accompanying drawings.

An embodiment of this application provides an electronic device. The electronic device may include a mobile phone (mobile phone), a tablet computer (pad), a television, an intelligent wearable product (for example, a smartwatch or a smart band), a virtual reality (virtual reality, VR) device, an augmented reality (augmented reality, AR) device, or the like. A specific form of the electronic device is not specially limited in embodiments of this application.

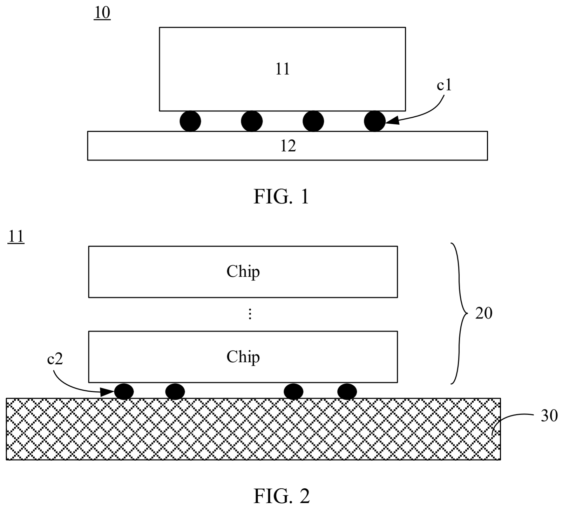

For example, refer to FIG. 1. An embodiment of this application provides a diagram of a structure of the foregoing electronic device. The electronic device 10 includes a printed circuit board (printed circuit board, PCB) 12 and a chip package structure 11. The chip package structure 11 is electrically connected to the PCB 12. Therefore, the chip package structure 11 can be interconnected with another chip or another module on the PCB 12. For example, refer to FIG. 1. An electrical connection structure c1 is further disposed between the chip package structure 11 and the PCB 12. The electrical connection structure c1 may be a ball grid array (ball grid array, BGA). The chip package structure 11 is specifically electrically connected to the PCB 12 via the electrical connection structure c1.

FIG. 2 shows the chip package structure 11. The chip package structure 11 includes a package substrate 30 and a chip stacked structure 20 constructed by using a three-dimensional (three-dimensional, 3D) stacked packaging technology. The chip package structure 11 is electrically connected to the PCB 12. Specifically, the package substrate 30 of the chip package structure 11 is electrically connected to the PCB 12. The chip stacked structure 20 includes two or more vertically stacked chips, and the chip stacked structure 20 is electrically connected to the package substrate 30. For example, refer to FIG. 2. An electrical connection structure c2 is further disposed between the chip stacked structure 20 and the package substrate 30. The electrical connection structure c2 may be a micro bump (micro bump, uBump), or may be a controllable collapse chip connection (controlled collapse chip connection, C4 for short) solder bump. The chip stacked structure 20 is specifically electrically connected to the package substrate 30 via the electrical connection structure c2.

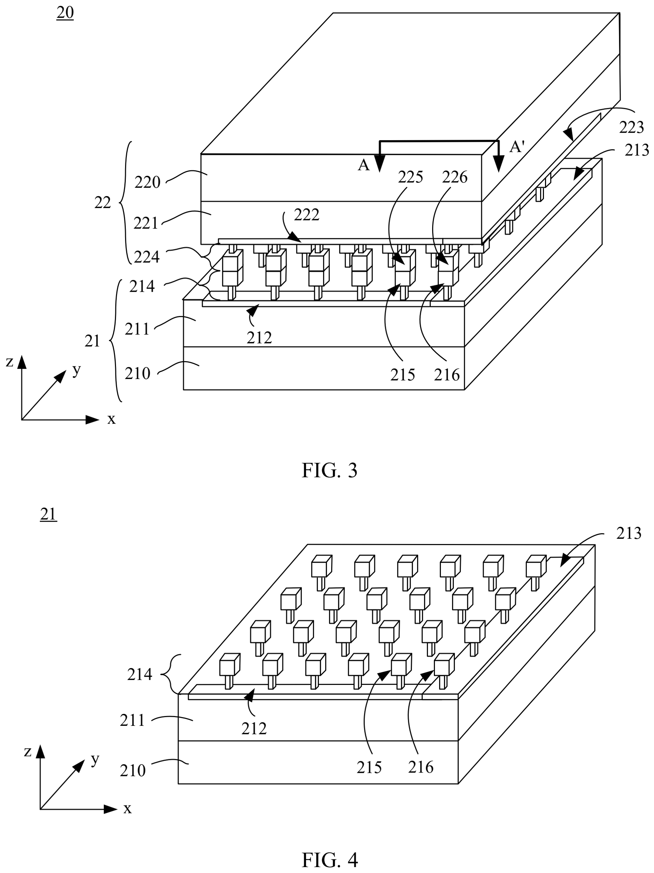

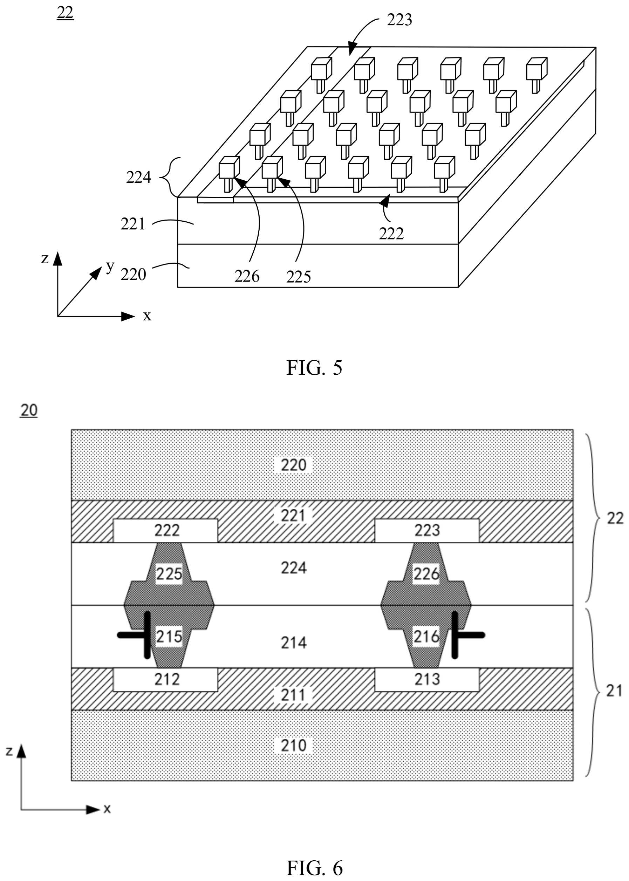

For example, FIG. 3 is a diagram of the chip stacked structure 20 shown in FIG. 2. The chip stacked structure 20 includes a chip 21 and a chip 22. Specifically, based on placement locations in the chip stacked structure shown in FIG. 3, the chip 21 is located below, and the chip 22 and the chip 21 are bonded above the chip 21. The following describes the chip stacked structure 20 provided in an embodiment of this application with reference to a diagram of a structure of the chip 21 shown in FIG. 4, a diagram of a structure of the chip 22 shown in FIG. 5, and a sectional view of FIG. 3 along AA' shown in FIG. 6.

Specifically, refer to FIG. 4. An embodiment of this application provides the diagram of the structure of the chip 21. The chip 21 includes a die 210, and electronic components are disposed on the die 210. The electronic components disposed on the die 210 include a capacitor, a resistor, a diode (diode), a triode (bipolar junction transistor, BJT), a metal-oxide semiconductor field-effect transistor (metal-oxide semiconductor field-effect transistor, MOSFET), and the like.

Refer to FIG. 4. The chip 21 further includes a dielectric layer 211 disposed on a side of the die 210. One or more metal routings are disposed at the dielectric layer 211. FIG. 4 and FIG. 6 show two metal routings: a metal routing 212 and a metal routing 213. The one or more metal routings at the dielectric layer 211 are electrically connected to the electronic components disposed on the die 210 to form a circuit structure. In some embodiments, the dielectric layer 211 of the chip 21 and the one or more metal routings disposed at the dielectric layer 211 are also referred to as a redistribution layer (redistribution layer, RDL).

Refer to FIG. 4 and FIG. 6. The chip 21 further includes a dielectric layer 214 disposed on a side that is of the dielectric layer 211 and that is away from the die 210. The chip 21 further includes a plurality of bonding devices that penetrate the dielectric layer 214. The plurality of bonding devices are arranged in an array, and one metal routing at the dielectric layer 211 is electrically connected to one or more bonding devices. For example, FIG. 4 and FIG. 6 show two bonding devices. The two bonding devices are adjacent, there is no other bonding device between the two bonding devices, and the two bonding devices are: a bonding device 215 and a bonding device 216. The metal routing 212 is electrically connected to the bonding device 215, and the metal routing 213 is connected to the bonding device 216. The chip 21 is bonded with another chip in the chip stacked structure 20 via the dielectric layer 214 and the plurality of bonding devices that penetrate the dielectric layer 214.

For example, refer to FIG. 5. An embodiment of this application provides the diagram of the structure of the chip 22. The chip 22 includes a die 220, and electronic components are disposed on the die 220. The electronic components disposed on the die 220 include a capacitor, a resistor, a diode (diode), a BJT, a MOSFET, and the like.

Refer to FIG. 5. The chip 22 further includes a dielectric layer 221 disposed on a side of the die 220. One or more metal routings are disposed at the dielectric layer 221. FIG. 5 and FIG. 6 show two metal routings: a metal routing 222 and a metal routing 223. The one or more metal routings at the dielectric layer 221 are electrically connected to the electronic components disposed on the die 220 to form a circuit structure. In some embodiments, the dielectric layer 221 of the chip 22 and the one or more metal routings disposed at the dielectric layer 221 are also referred to as an RDL.

Refer to FIG. 5 and FIG. 6. The chip 22 further includes a dielectric layer 224 disposed on a side that is of the dielectric layer 221 and that is away from the die 220. The chip 22 further includes a plurality of bonding devices that penetrate the dielectric layer 224. The plurality of bonding devices are arranged in an array, and one metal routing at the dielectric layer 221 is electrically connected to one or more bonding devices. For example, FIG. 5 and FIG. 6 show two bonding devices. The two bonding devices are adjacent, there is no other bonding device between the two bonding devices, and the two bonding devices are: a bonding device 225 and a bonding device 226. The metal routing 222 is electrically connected to the bonding device 225, and the metal routing 223 is electrically connected to the bonding device 226. The chip 22 is bonded with another chip in the chip stacked structure 20 via the dielectric layer 224 and the plurality of bonding devices that penetrate the dielectric layer 224.

Refer to FIG. 3. The chip 21 bonded with the chip 22. Specifically, the chip 21 includes bonding devices arranged in an array of M rows and N columns, M and N are positive integers greater than or equal to 1, and a product of M and N is greater than or equal to 2. The chip 22 also includes bonding devices arranged in the array of M rows and N columns, and the bonding devices arranged in the array of M rows and N columns in the chip 21 and the bonding devices arranged in the array of M rows and N columns in the chip 22 are aligned one by one to perform bonding, to form the chip stacked structure shown in FIG. 3. Specifically, as shown in FIG. 3, the bonding device 215 is electrically connected to the bonding device 225, and the bonding device 216 is electrically connected to the bonding device 226.

For example, in the chip stacked structure 20 shown in FIG. 3, a signal received by an electronic component disposed on the die 210 of the chip 21 may be transmitted to an electronic component disposed on the die 220 of the chip 22 via the metal routing 212, the bonding device 215, the bonding device 225, and the metal routing 222; and the signal received by the electronic component disposed on the die 210 of the chip 21 may alternatively be transmitted to the electronic component disposed on the die 220 of the chip 22 via the metal routing 213, the bonding device 216, the bonding device 226, and the metal routing 223. Alternatively, a signal received by an electronic component disposed on the die 220 of the chip 22 may be transmitted to an electronic component disposed on the die 210 of the chip 21 via the metal routing 222, the bonding device 225, the bonding device 215, and the metal routing 212; and the signal received by the electronic component disposed on the die 220 of the chip 22 may alternatively be transmitted to the electronic component disposed on the die 210 of the chip 21 via the metal routing 223, the bonding device 226, the bonding device 216, and the metal routing 213. Therefore, the chip 21 and the chip 22 can implement signal interworking.

For example, refer to FIG. 6. In the chip stacked structure 20, when signal interworking is implemented between the chip 22 and the chip 21, the chip 21 is used as an example. A signal passes through the bonding device 215, and a signal passes through the bonding device 216. Because the dielectric layer 214 is further disposed between the bonding device 215 and the bonding device 216, the bonding device 215, the bonding device 216, and the dielectric layer 214 between the bonding device 215 and the bonding device 216 form a capacitor C. One electrode of the capacitor C is the bonding device 215, the other electrode of the capacitor C is the bonding device 216, and a dielectric material of the capacitor C is the dielectric layer 214 between the bonding device 215 and the bonding device 216. The capacitor C is also referred to as parasitic capacitance, and the parasitic capacitance causes a delay of the signal transmitted via the bonding device 215, and also causes a delay of the signal transmitted via the bonding device 216. Consequently, a resistive-capacitive delay (resistive-capacitive delay, RC delay) of the chip 21 increases, and signal transmission performance of the chip 21 is affected.

For example, refer to FIG. 6. A spacing between the bonding device 215 and the bonding device 216 is also referred to as an interconnection spacing. As interconnection density between chips increases greatly in recent years, the interconnection spacing of the chip 21 becomes increasingly small. Therefore, impact of parasitic capacitance between two adjacent bonding devices on the signal transmission performance of the chip 21 gradually increases.

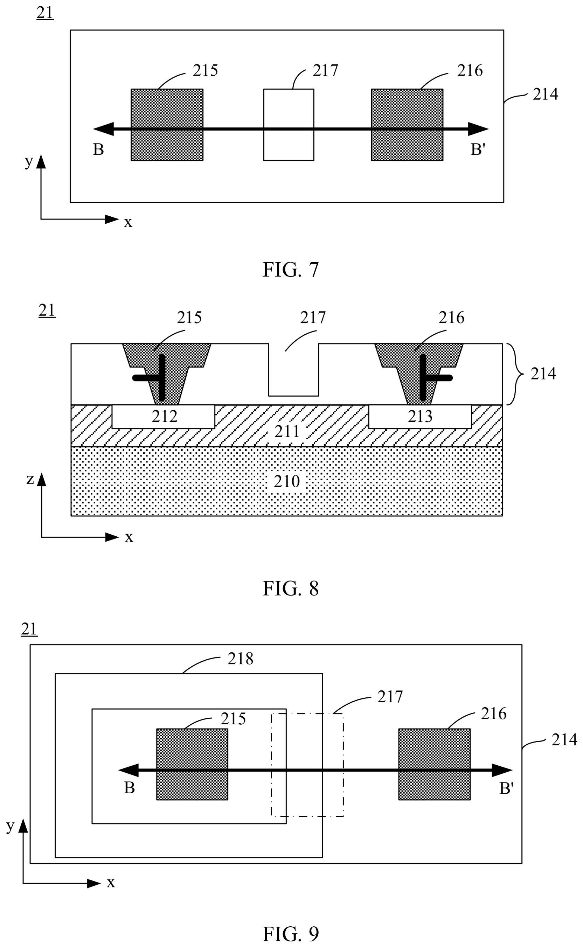

For example, an embodiment of this application provides a chip. Refer to FIG. 7. An embodiment of this application provides a top view of the chip 21. FIG. 8 is a sectional view of the chip 21 shown in FIG. 7 along BB'. Parasitic capacitance generated between two adjacent bonding devices of the chip 21 is small, so that signal transmission performance of the chip 21 is improved.

For example, refer to FIG. 8. The chip 21 includes the die 210, electronic components are disposed on the die 210, and the chip 21 further includes the dielectric layer 214 disposed on a side of the die 210. Specifically, the dielectric layer 214 is disposed on a side in a z direction of the die 210. The chip 21 further includes a plurality of bonding devices that penetrate the dielectric layer 214. The plurality of bonding devices include the bonding device 215 and the bonding device 216 that are adjacent to each other. There is no other bonding device between the bonding device 215 and the bonding device 216. The bonding device 215 is electrically connected to an electronic component of the die 210, and the bonding device 216 is electrically connected to an electronic component of the die 210.

When the chip stacked structure 20 includes the chip 21 shown in FIG. 7 and FIG. 8, the chip 21 is bonded with another chip in the chip stacked structure 20 via the dielectric layer 214 and the plurality of bonding devices that penetrate the dielectric layer 214. Specifically, the bonding device 215 of the chip 21 is electrically connected to a bonding device of the another chip; the bonding device 216 of the chip 21 is electrically connected to a bonding device of the another chip; and the dielectric layer 214 of the chip 21 is fused with a dielectric layer of the another chip, or the dielectric layer 214 of the chip 21 is in contact with a dielectric layer of the another chip.

For example, when signal interworking is implemented between the chip 21 and the another chip in the chip stacked structure 20, usually, a signal passes through the bonding device 215, and a signal passes through the bonding device 216, so that an electronic component disposed on the die 210 receives a signal transmitted by the another chip or transmits a signal to the another chip. The signal passes through the bonding device 215, the signal passes through the bonding device 216, and parasitic capacitance exists between the bonding device 215 and the bonding device 216. To reduce the parasitic capacitance generated between the bonding device 215 and the bonding device 216, in the chip 21 shown in FIG. 8, a channel 217 between the bonding device 215 and the bonding device 216 is formed at the dielectric layer 214, and a dielectric constant of the channel 217 is less than a dielectric constant of a material of the dielectric layer 214. The channel 217 may be a groove disposed at the dielectric layer 214, and an upper surface of the channel 217 is an opening; or the channel 217 is a path disposed at the dielectric layer 214, and the channel 217 is completely buried at the dielectric layer 214. Specifically, refer to FIG. 7. The chip shown in FIG. 7 and FIG. 8 is described by using an example in which the channel 217 is the groove disposed at the dielectric layer 214, and the upper surface of the channel 217 is the opening.

For example, the material of the dielectric layer 214 includes one or more of the following: silicon oxide, silicon nitride, silicon oxynitride, and nitrogen-doped silicon carbide. A dielectric constant of the silicon oxide is about 4, a dielectric constant of the silicon nitride is between 4 and 13, a dielectric constant of the silicon oxynitride is between 3.5 and 8.0, and a dielectric constant of the nitrogen-doped silicon carbide is between 4.0 and 5.0.

For example, the channel 217 is filled with air, and a dielectric constant of the air is approximately equal to 1; or the channel 217 is filled with an inert gas, and a dielectric constant of the inert gas is approximately equal to 1; or the channel 217 is of a vacuum environment, and a dielectric constant of the vacuum environment is 1. Alternatively, the channel 217 is filled with a predetermined material, a dielectric constant of the predetermined material is less than the dielectric constant of the material of the dielectric layer 214, and the predetermined material includes one or more of the following: SiLK, hydrogen silsesquioxane (HSQ), methyl silsesquioxane (MSQ), and nanoglass.

Therefore, in the chip 21 shown in FIG. 8, when the chip 21 is bonded with the another chip and signal interworking is implemented, the signal passes through the bonding device 215, the signal passes through the bonding device 216, and the channel 217 between the bonding device 215 and the bonding device 216 is formed at the dielectric layer 214. The bonding device 215, the bonding device 216, and the dielectric layer 214 and the channel 217 that are between the bonding device 215 and the bonding device 216 form a capacitor C1. One electrode of the capacitor C1 is the bonding device 215, the other electrode of the capacitor C1 is the bonding device 216, and a dielectric material of the capacitor C1 includes the dielectric layer 214 and the channel 217. Because the dielectric constant of the channel 217 is less than the dielectric constant of the material of the dielectric layer 214, a dielectric constant of the combination of the dielectric layer 214 and the channel 217 is less than the dielectric constant of the dielectric layer 214, so that a capacitance value of the capacitor C1 is less than the capacitance value of the capacitor C shown in FIG. 6. When the capacitance value of the capacitor C1 is small, a delay of the signal transmitted via the bonding device 215 is reduced, and a delay of the signal transmitted via the bonding device 216 is also reduced, so that an RC delay of the chip 21 shown in FIG. 8 is reduced, and signal transmission performance of the chip 21 is improved. For example, the channel 217 shown in FIG. 7 and FIG. 8 includes a rectangular subchannel. To reduce the parasitic capacitance generated between the bonding device 215 and the bonding device 216, a size of the rectangular subchannel should not be excessively small. For example, a length of the rectangular subchannel along an x-axis is greater than or equal to one tenth of a length of a distance between the bonding device 215 and the bonding device 216 along the x-axis; a width of the rectangular subchannel along a y-axis is greater than or equal to one fifth of a width of the bonding device 215 or the bonding device 216 along the y-axis; and a depth of the rectangular subchannel along a z-axis is greater than or equal to one fifth of a depth of the bonding device 215 or the bonding device 216 along the z-axis. When the size of the rectangular subchannel is excessively small, the channel 217 may slightly reduce the parasitic capacitance generated between the bonding device 215 and the bonding device 216.

In addition, the channel 217 includes a rectangular subchannel. To prevent a size of the channel 217 from affecting subsequent bonding effect of the chip 21, a size of the rectangular subchannel should not be excessively large. For example, a length of the rectangular subchannel along the x-axis is less than or equal to two thirds of the length of the distance between the bonding device 215 and the bonding device 216 along the x-axis.

The channel 217 includes a rectangular subchannel. Generally, a size of the rectangular subchannel is properly designed based on a proportion of the parasitic capacitance generated between the bonding device 215 and the bonding device 216 that needs to be reduced and a layout size of the chip 21.

For example, in some other embodiments, the channel 217 may further include a plurality of rectangular subchannels. An arrangement manner of the plurality of rectangular subchannels is not limited in embodiments of this application. For example, the plurality of rectangular subchannels may be arranged in an array or in a staggered manner. A sum of lengths of the plurality of rectangular subchannels along the x-axis is greater than or equal to one tenth of the length of the distance between the bonding device 215 and the bonding device 216 along the x-axis; a sum of sizes of the plurality of rectangular subchannels along the x-axis is less than or equal to two thirds of the length of the distance between the bonding device 215 and the bonding device 216 along the x-axis; a sum of widths of the plurality of rectangular subchannels along the y-axis is greater than or equal to one fifth of the width of the bonding device 215 or the bonding device 216 along the y-axis; and a maximum depth of the plurality of rectangular subchannels along the z-axis is greater than or equal to one fifth of the depth of the bonding device 215 or the bonding device 216 along the z-axis.

In some embodiments, refer to FIG. 9. An embodiment of this application provides a top view of another chip 21. A sectional view of the chip 21 shown in FIG. 9 along BB' is shown in FIG. 8. In the chip 21 shown in FIG. 9, a channel 218 surrounding the bonding device 215 is formed at the dielectric layer 214, and the channel 217 includes a part that is of the channel 218 and that is located between the bonding device 215 and the bonding device 216. In the top view of the chip 21 shown in FIG. 9, a top view shape of the channel 218 is a rectangular ring. In some other embodiments, the top view shape of the channel 218 may be a circular ring, or the top view shape of the channel 218 may be a polygonal ring. This is not limited in embodiments of this application.

For example, as shown in FIG. 9, when the channel 218 surrounding the bonding device 215 is formed at the dielectric layer 214, and the top view shape of the channel 218 is the rectangular ring, in the chip 21, the bonding device 216 is located in an x direction of the bonding device 215, and the channel 217, that is, the part that is of the channel 218 and that is located between the bonding device 215 and the bonding device 216, can reduce parasitic capacitance between the bonding device 215 and the bonding device 216. When a predetermined bonding device is located in a -x direction of the bonding device 215, a part that is of the channel 218 and that is located in the -x direction of the bonding device 215 can reduce parasitic capacitance between the predetermined bonding device and the bonding device 215; and/or when the predetermined bonding device is located in a -y direction of the bonding device 215, a part that is of the channel 218 and that is located in the -y direction of the bonding device 215 can reduce the parasitic capacitance between the predetermined bonding device and the bonding device 215; and/or when the predetermined bonding device is located in a y direction of the bonding device 215, a part that is of the channel 218 and that is located in the y direction of the bonding device 215 can reduce the parasitic capacitance between the predetermined bonding device and the bonding device 215.

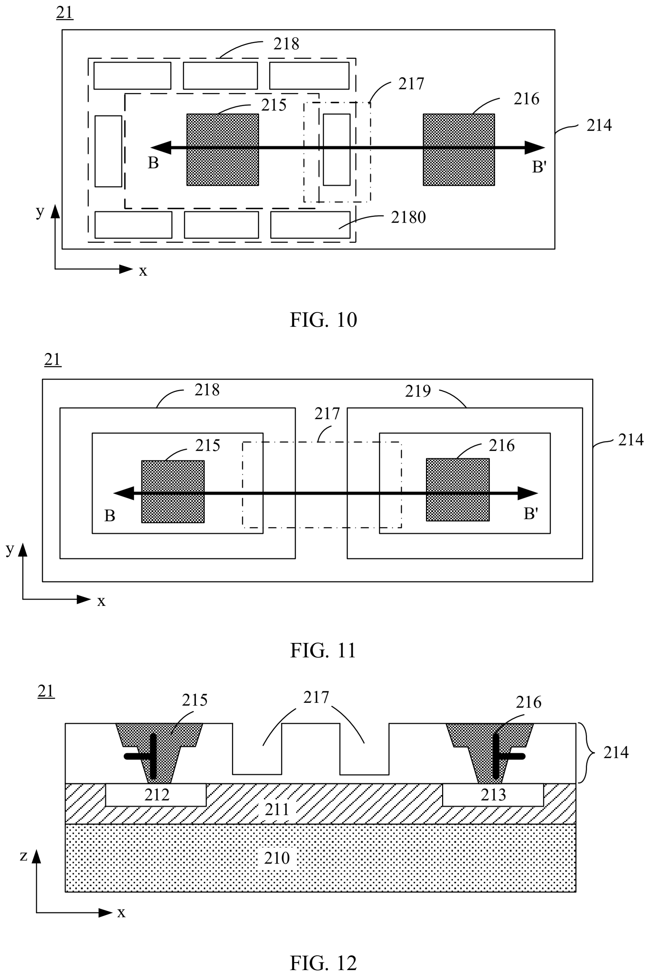

In some other embodiments, refer to FIG. 10. An embodiment of this application provides a top view of another chip 21. A sectional view of the chip 21 shown in FIG. 10 along BB' is shown in FIG. 8. In the chip 21 shown in FIG. 10, a channel 218 surrounding the bonding device 215 is formed at the dielectric layer 214, the channel 218 includes a plurality of spaced subchannels 2180, and the channel 217 includes a part of subchannels 2180 that are of the channel 218 and that are located between the bonding device 215 and the bonding device 216.

As shown in FIG. 10, in the chip 21, the bonding device 216 is located in an x direction of the bonding device 215, and the channel 217, that is, the part of subchannels 2180 that are of the channel 218 and that are between the bonding device 215 and the bonding device 216, can reduce parasitic capacitance between the bonding device 215 and the bonding device 216. When a predetermined bonding device is located in a -x direction of the bonding device 215, a part of subchannels 2180 that are of the channel 218 and that are located in the -x direction of the bonding device 215 can reduce parasitic capacitance between the predetermined bonding device and the bonding device 215; and/or when the predetermined bonding device is located in a -y direction of the bonding device 215, a part of subchannels 2180 that are of the channel 218 and that are located in the -y direction of the bonding device 215 can reduce the parasitic capacitance between the predetermined bonding device and the bonding device 215; and/or when the predetermined bonding device is located in a y direction of the bonding device 215, a part of subchannels 2180 that are of the channel 218 and that are located in the y direction of the bonding device 215 can reduce the parasitic capacitance between the predetermined bonding device and the bonding device 215.

In some embodiments, refer to FIG. 11. An embodiment of this application provides a top view of another chip 21. FIG. 12 is a cross-sectional view of the chip 21 shown in FIG. 11 along BB'. In the chip 21 shown in FIG. 11, a channel 218 surrounding the bonding device 215 is formed at the dielectric layer 214, and the channel 217 includes a part that is of the channel 218 and that is located between the bonding device 215 and the bonding device 216. A channel 219 surrounding the bonding device 216 is also formed at the dielectric layer 214, and the channel 217 includes a part that is of the channel 219 and that is located between the bonding device 215 and the bonding device 216. In the top view of the chip 21 shown in FIG. 11, a top view shape of the channel 219 is a rectangular ring. In some other embodiments, the top view shape of the channel 219 may be a circular ring, or the top view shape of the channel 219 may be a polygonal ring. This is not limited in embodiments of this application.

For example, a top view structure of the channel 218 shown in FIG. 11 is shown in FIG. 9. In some other embodiments, the top view structure of the channel 218 shown in FIG. 11 may also be shown in FIG. 10, and the channel 218 may include a plurality of spaced subchannels 2180.

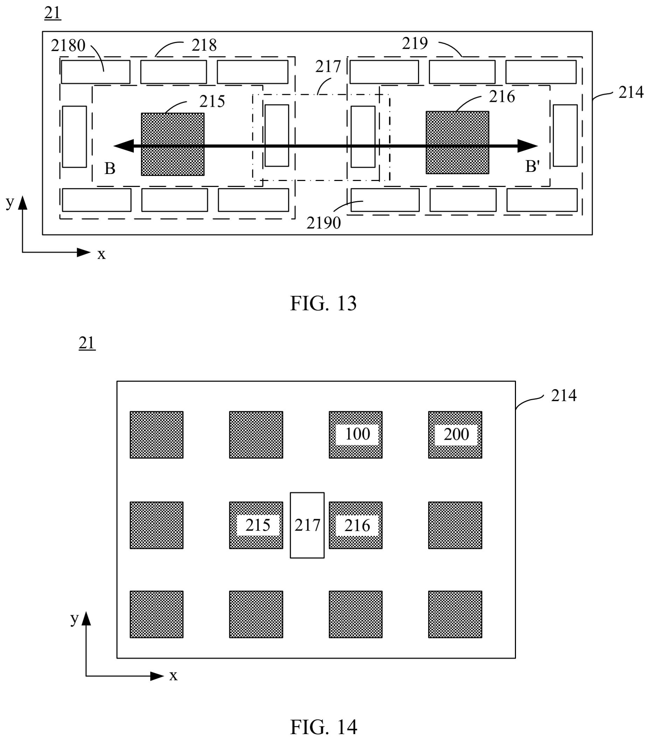

For example, as shown in FIG. 11, when the channel 219 surrounding the bonding device 216 is formed at the dielectric layer 214, and the top view shape of the channel 219 is the rectangular ring, in the chip 21, the bonding device 215 is located in a -x direction of the bonding device 216, and the part that is of the channel 219 and that is located between the bonding device 215 and the bonding device 216 can reduce parasitic capacitance between the bonding device 215 and the bonding device 216. When a predetermined bonding device is located in an x direction of the bonding device 216, a part that is of the channel 219 and that is located in the x direction of the bonding device 216 can reduce parasitic capacitance between the predetermined bonding device and the bonding device 216; and/or when the predetermined bonding device is located in a -y direction of the bonding device 216, a part that is of the channel 219 and that is located in the -y direction of the bonding device 216 can reduce the parasitic capacitance between the predetermined bonding device and the bonding device 216; and/or when the predetermined bonding device is located in a y direction of the bonding device 216, a part that is of the channel 219 and that is located in the y direction of the bonding device 216 can reduce the parasitic capacitance between the predetermined bonding device and the bonding device 216. In some other embodiments, refer to FIG. 13. An embodiment of this application provides a top view of another chip 21. A sectional view of the chip 21 shown in FIG. 13 along BB' is shown in FIG. 12. In the chip 21 shown in FIG. 13, a channel 218 surrounding the bonding device 215 is formed at the dielectric layer 214, the channel 218 includes a plurality of spaced subchannels 2180, and the channel 217 includes a part of subchannels 2180 that are of the channel 218 and that are located between the bonding device 215 and the bonding device 216. A channel 219 surrounding the bonding device 216 is further formed at the dielectric layer 214, the channel 219 includes a plurality of spaced subchannels 2190, and the channel 217 includes a part of subchannels 2190 that are of the channel 219 and that are located between the bonding device 215 and the bonding device 216.

For example, a top view structure of the channel 218 shown in FIG. 13 is shown in FIG. 10. In some other embodiments, the top view structure of the channel 218 shown in FIG. 13 may also be shown in FIG. 9.

As shown in FIG. 13, in the chip 21, the bonding device 215 is located in a -x direction of the bonding device 216, and the part of subchannels 2190 that are of the channel 219 and that are between the bonding device 215 and the bonding device 216 can reduce parasitic capacitance between the bonding device 215 and the bonding device 216. When a predetermined bonding device is located in an x direction of the bonding device 216, a part of subchannels 2190 that are of the channel 219 and that are located in the x direction of the bonding device 216 can reduce parasitic capacitance between the predetermined bonding device and the bonding device 216; and/or when the predetermined bonding device is located in a -y direction of the bonding device 216, a part of subchannels 2190 that are of the channel 219 and that are located in the -y direction of the bonding device 216 can reduce the parasitic capacitance between the predetermined bonding device and the bonding device 216; and/or when the predetermined bonding device is located in a y direction of the bonding device 216, a part of subchannels 2190 that are of the channel 219 and that are located in the y direction of the bonding device 216 can reduce the parasitic capacitance between the predetermined bonding device and the bonding device 216.

For example, refer to FIG. 8 or FIG. 12. The dielectric layer 211 is further disposed between the die 210 and the dielectric layer 214 of the chip 21. One or more metal routings are disposed at the dielectric layer 211, and the one or more metal routings at the dielectric layer 211 and the electronic components of the die 210 form a predetermined circuit structure. The dielectric layer 211 and the one or more metal routings at the dielectric layer 211 are also referred to as the RDL of the chip 21. For example, the dielectric layer 211 may be a one-layer or multi-layer stacked structure. This is not limited in embodiments of this application.

For example, the chip 21 is bonded with another chip in the chip stacked structure 20 via the dielectric layer 214 and the plurality of bonding devices that penetrate the dielectric layer 214, and one metal routing at the dielectric layer 211 is further electrically connected to one or more bonding devices. In this case, the bonding device is specifically electrically connected to the electronic component of the die 210 via the metal routing at the dielectric layer 211.

Refer to FIG. 8 and FIG. 12. In a first example, the metal routing 212 is disposed at the dielectric layer 211. The metal routing 212 is electrically connected to the bonding device 215, and the metal routing 212 is electrically connected to the bonding device 216. In this case, the bonding device 215 is electrically connected to the electronic component of the die 210. Specifically, the bonding device 215 is electrically connected to the metal routing 212, and the metal routing 212 is electrically connected to the electronic component of the die 210. The bonding device 216 is electrically connected to the electronic component of the die 210. Specifically, the bonding device 216 is electrically connected to the metal routing 212, and the metal routing 212 is electrically connected to the electronic component of the die 210.

In a second example, the metal routing 212 and the metal routing 213 are disposed at the dielectric layer 211. The metal routing 212 is electrically connected to the bonding device 215, and the metal routing 213 is electrically connected to the bonding device 216. In this case, the bonding device 215 is electrically connected to the electronic component of the die 210. Specifically, the bonding device 215 is electrically connected to the metal routing 212, and the metal routing 212 is electrically connected to the electronic component of the die 210. The bonding device 216 is electrically connected to the electronic component of the die 210. Specifically, the bonding device 216 is electrically connected to the metal routing 213, and the metal routing 213 is electrically connected to the electronic component of the die 210. FIG. 8 and FIG. 12 are drawn by using the content in the second example as an example.

In the third example, the metal routing 213 is disposed at the dielectric layer 211. Alternatively, the metal routing 213 is electrically connected to the bonding device 215, and the metal routing 213 is electrically connected to the bonding device 216. In a fourth example, the metal routing 212 and the metal routing 213 are disposed at the dielectric layer 214. Alternatively, the metal routing 213 is electrically connected to the bonding device 215, and the metal routing 212 is electrically connected to the bonding device 216. This is not limited in embodiments of this application.

For example, in some other embodiments, refer to FIG. 14. A plurality of bonding devices of the chip 21 further include a bonding device 100 and a bonding device 200 that are adjacent to each other. There is no other bonding device between the bonding device 100 and the bonding device 200. The bonding device 215 is adjacent to the bonding device 216 in an x-axis direction, and the bonding device 100 is adjacent to the bonding device 200 in the x-axis direction. No channel is disposed between the bonding device 100 and the bonding device 200. The bonding device 100 shown in FIG. 14 is adjacent to the bonding device 216. In some other embodiments, the bonding device 100 may be not adjacent to the bonding device 216. The bonding device 100 may be adjacent to or not adjacent to the bonding device 215. The bonding device 200 may be adjacent to or not adjacent to the bonding device 215. The bonding device 200 may be adjacent to or not adjacent to the bonding device 216. This is not limited in this embodiment of this application.

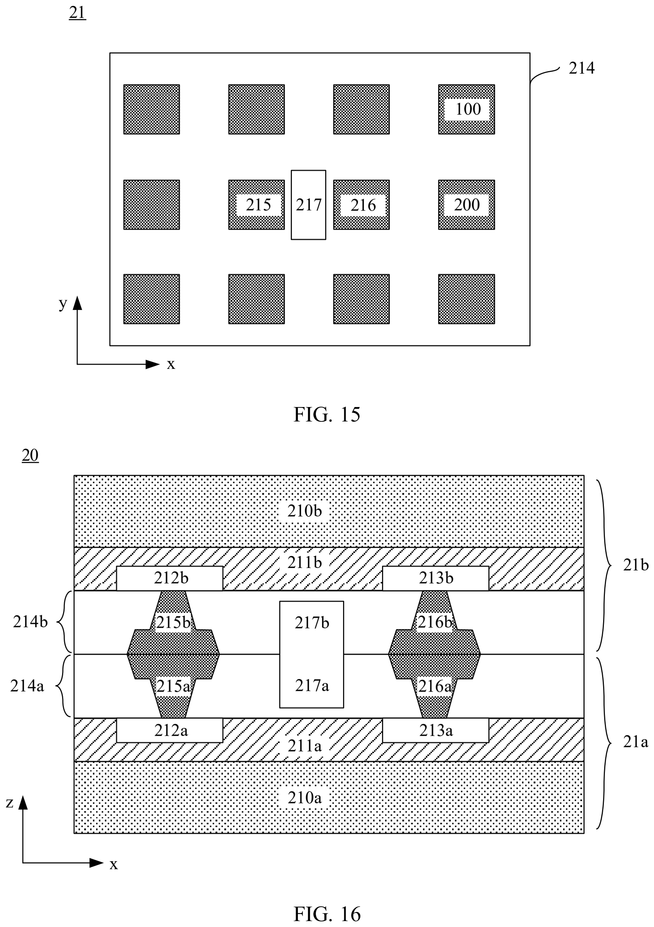

Alternatively, refer to FIG. 15. A plurality of bonding devices of the chip 21 further include a bonding device 100 and a bonding device 200 that are adjacent to each other. There is no other bonding device between the bonding device 100 and the bonding device 200. The bonding device 215 is adjacent to the bonding device 216 in an x-axis direction, and the bonding device 100 is adjacent to the bonding device 200 in a y-axis direction. The x-axis direction crosses the y-axis direction. The bonding device 200 shown in FIG. 15 is adjacent to the bonding device 216. In some other embodiments, the bonding device 200 may be not adjacent to the bonding device 216. The bonding device 100 may be adjacent to or not adjacent to the bonding device 215. The bonding device 100 may be adjacent to or not adjacent to the bonding device 216. The bonding device 200 may be adjacent to or not adjacent to the bonding device 215. This is not limited in this embodiment of this application.

According to the foregoing embodiment, it can be learned that the plurality of bonding devices of the chip 21 may be, for example, bonding devices arranged in an M*N array, and interconnection density of the chip 21 may increase as a value of M and/or N increases. In the bonding devices arranged in the M*N array, a channel may be disposed between a plurality of adjacent bonding devices, or no channel may be disposed between a plurality of adjacent bonding devices. This is not limited in this embodiment of this application.

The chip stacked structure 20 shown in FIG. 2 includes a plurality of stacked chips. The plurality of stacked chips include the chip 21 shown in any one of FIG. 7 to FIG. 15. The chip 21 is bonded with another chip via the dielectric layer 214 and a plurality of bonding devices that penetrate the dielectric layer 214.

In some other embodiments, refer to FIG. 16. An embodiment of this application provides a diagram of the chip stacked structure 20. The chip stacked structure 20 includes a plurality of stacked chips. The plurality of stacked chips include a chip 21a and a chip 21b. The chip 21a and the chip 21b are a first chip and a second chip in the plurality of stacked chips. The chip 21a may be the chip 21 shown in any one of FIG. 7 to FIG. 15. The chip 21b may be the chip 21 shown in any one of FIG. 7 to FIG. 15.

The chip 21a includes a die 210a and a dielectric layer 214a disposed on a side of the die 210a. The chip 21a further includes a plurality of bonding devices that penetrate the dielectric layer 214a. The plurality of bonding devices include a bonding device 215a and a bonding device 216a that are adjacent to each other. There is no other bonding device between the bonding device 215a and the bonding device 216a, a channel 217a between the bonding device 215a and the bonding device 216a is formed at the dielectric layer 214a, and a dielectric constant of the channel 217a is less than a dielectric constant of a material of the dielectric layer 214a. The chip 21b includes a die 210b and a dielectric layer 214b disposed on a side of the die 210b. The chip 21b further includes a plurality of bonding devices that penetrate the dielectric layer 214b. The plurality of bonding devices include a bonding device 215b and a bonding device 216b that are adjacent to each other. There is no other bonding device between the bonding device 215b and the bonding device 216b, a channel 217b between the bonding device 215b and the bonding device 216b is formed at the dielectric layer 214b, and a dielectric constant of the channel 217b is less than a dielectric constant of a material of the dielectric layer 214b.

In the chip stacked structure 20 shown in FIG. 16, the chip 21a is bonded with the chip 21b, the bonding device 215a is electrically connected to the bonding device 215b, the bonding device 216a is electrically connected to the bonding device 216b, and the channel 217a is aligned with the channel 217b. The dielectric layer 214a is fused with the dielectric layer 214b, or the dielectric layer 214a is in contact with the dielectric layer 214b. For example, a layout of the dielectric layer 214a of the chip 21a is the same as a layout of the dielectric layer 214b of the chip 21b. For example, if the layout of the dielectric layer 214a of the chip 21a is a layout of the dielectric layer 214 of the chip 21 shown in FIG. 7, the layout of the dielectric layer 214b of the chip 21b is also the layout of the dielectric layer 214 of the chip 21 shown in FIG. 7. Alternatively, in some other embodiments, a layout of the dielectric layer 214a of the chip 21a is different from a layout of the dielectric layer 214b of the chip 21b. The layout of the dielectric layer 214a of the chip 21a and the layout of the dielectric layer 214b of the chip 21b are not limited in this embodiment of this application.

In some embodiments, when the channel 217a of the chip 21a is a groove disposed at the dielectric layer 214a, an upper surface of the channel 217a is an opening, and the channel 217a is not filled with an actual material, and when the channel 217b of the chip 21b is a groove disposed at the dielectric layer 214b, an upper surface of the channel 217b is an opening, and the channel 217b is not filled with an actual material, the chip 21a is bonded with the chip 21b, and the channel 217a is aligned with the channel 217b to form an aligned structure. When the chip stacked structure 20 is manufactured in an air environment, the aligned structure is filled with air. When the chip stacked structure 20 is manufactured in an inert gas environment, the aligned structure is filled with an inert gas. When the chip stacked structure 20 is manufactured in a vacuum environment, an inner part of the aligned structure is of a vacuum environment.

For example, as shown in FIG. 16, the dielectric layer 214a of the chip 21a is disposed on a side of an active surface of the chip 21a, the dielectric layer 214b of the chip 21b is disposed on a side of an active surface of the chip 21b, and the active surface of the chip 21a is bonded with the active surface of the chip 21b via the dielectric layer 214a, the plurality of bonding devices that penetrate the dielectric layer 214a, the plurality of bonding devices that penetrate the dielectric layer 214b, and the dielectric layer 214b. This bonding manner is also referred to as face-to-face (face-to-face) bonding.

Alternatively, the dielectric layer 214a of the chip 21a is disposed on a side of an active surface of the chip 21a, the dielectric layer 214b of the chip 21b is disposed on a side of a passive surface of the chip 21b, and the active surface of the chip 21a is bonded with the passive surface of the chip 21b via the dielectric layer 214a, the plurality of bonding devices that penetrate the dielectric layer 214a, the plurality of bonding devices that penetrate the dielectric layer 214b, and the dielectric layer 214b. This bonding manner is also referred to as face-to-back (face-to-back) bonding.

Alternatively, the dielectric layer 214a of the chip 21a is disposed on a side of a passive surface of the chip 21a, the dielectric layer 214b of the chip 21b is disposed on a side of a passive surface of the chip 21b, and the passive surface of the chip 21a is bonded with the passive surface of the chip 21b via the dielectric layer 214a, the plurality of bonding devices that penetrate the dielectric layer 214a, the plurality of bonding devices that penetrate the dielectric layer 214b, and the dielectric layer 214b. This bonding manner is also referred to as back-to-back (back-to-back) bonding.

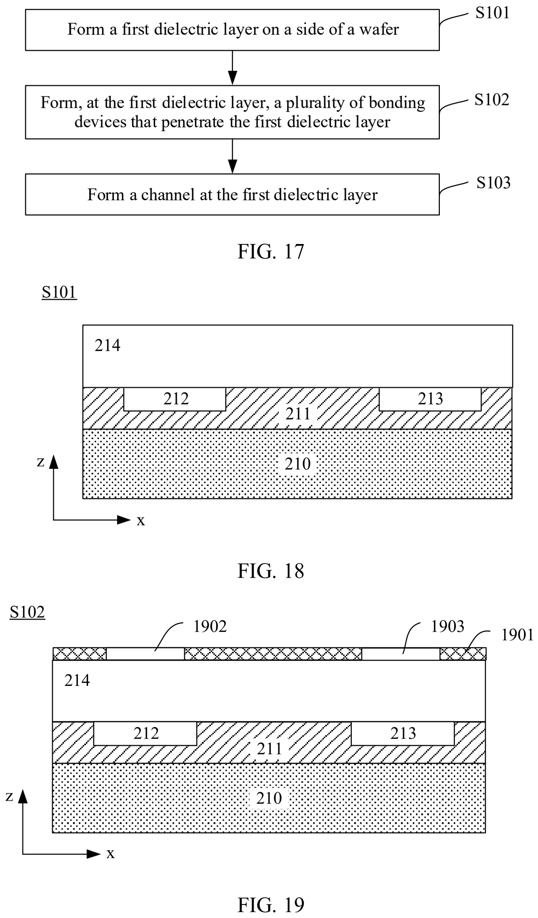

Refer to FIG. 17. An embodiment of this application further provides a manufacturing method for a chip. The chip 21 shown in FIG. 8 may be manufactured according to the manufacturing method for a chip. Specifically, the manufacturing method for a chip includes the following steps.

S101: Form a first dielectric layer on a side of a die.

For example, refer to FIG. 18. When the chip 21 needs to be manufactured, the die 210 needs to be prepared first. Generally, before step S101 is performed, the dielectric layer 211 further needs to be formed on a side of the die 210. Refer to FIG. 18. Specifically, a dielectric layer material is deposited on a side in a z direction of the die 210 by using a chemical vapor deposition (chemical vapor deposition, CVD) process. The dielectric layer material includes one or more of the following: silicon oxide, silicon nitride, silicon oxynitride, nitrogen-doped silicon carbide, and the like, to form the dielectric layer 211 on the side in the z direction of the die 210. One or more metal routings further need to be formed at the dielectric layer 211, and the one or more metal routings at the dielectric layer 211 are electrically connected to electronic components of the die 210 to form a predetermined circuit structure. The dielectric layer 211 and the one or more metal routings at the dielectric layer 211 are an RDL of the chip 21. FIG. 18 shows two metal routings: the metal routing 212 and the metal routing 213.

Then, step S101 is performed. Refer to FIG. 18. The dielectric layer material may be deposited by using the CVD process on the side in the z direction of the dielectric layer 211. The dielectric layer material includes one or more of the following: the silicon oxide, the silicon nitride, the silicon oxynitride, the nitrogen-doped silicon carbide, and the like, to further form the dielectric layer 214 (that is, the first dielectric layer) on the side that is of the dielectric layer 211 and that is away from the die 210.

S102: Form, at the first dielectric layer, a plurality of bonding devices that penetrate the first dielectric layer.

The plurality of bonding devices include a first bonding device and a second bonding device that are adjacent to each other.

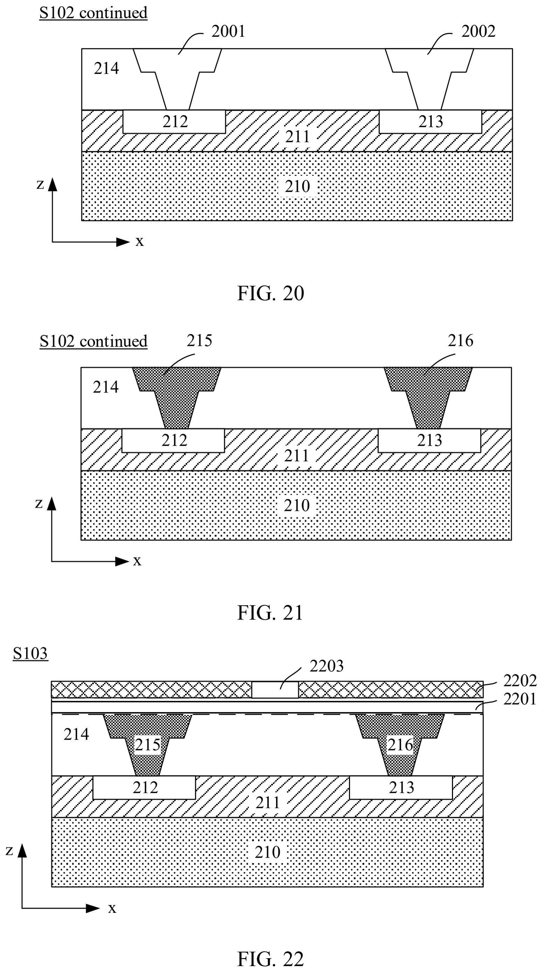

For example, in this embodiment of this application, an example in which the first bonding device and the second bonding device are formed is used for description. Refer to FIG. 19. A photoresist 1901 may be coated on a surface in the z direction of the dielectric layer 214 shown in FIG. 18. The photoresist 1901 may be a positive photoresist or a negative photoresist. The photoresist 1901 is shielded by a light shielding plate, and photoetching is performed, to form a bonding device pattern 1902 and a bonding device pattern 1903. Refer to FIG. 20, a dual-damascene process is usually used. The dielectric layer 214 is etched (etched) based on the bonding device pattern 1902 shown in FIG. 19, and the dielectric layer 214 is etched (etched) based on the bonding device pattern 1903, to form a bonding device window 2001 and a bonding device window 2002 shown in FIG. 20. Refer to FIG. 21. A bonding device material is electroplated by using an electrochemical plating (electrochemical plating, ECP) process in the bonding device window 2001 and the bonding device window 2002 shown in FIG. 20. The bonding device material includes one or more of the following: copper and tungsten, to form the bonding device 215 (that is, the first bonding device) and the bonding device 216 (that is, the second bonding device) shown in FIG. 21. The bonding device 215 shown in FIG. 21 is electrically connected to the metal routing 212, and the bonding device 216 is electrically connected to the metal routing 213.

In some other embodiments, only the metal routing 212 is disposed at the dielectric layer 211, and the dielectric layer 214 is etched (etched) by using the dual-damascene process based on the bonding device pattern 1902 and the bonding device pattern 1903, and a bonding device material is electroplated. The formed bonding device 215 is electrically connected to the metal routing 212, and the bonding device 216 is electrically connected to the metal routing 212. Locations of the bonding device pattern 1902 and the bonding device pattern 1903 are controlled, so that the formed bonding device 215 can be electrically connected to any metal routing of the dielectric layer 211, and the bonding device 216 can be electrically connected to any metal routing of the dielectric layer 211. This is not limited in this embodiment of this application.

In some embodiments, step S102 specifically includes: forming the plurality of bonding devices at the first dielectric layer. The plurality of bonding devices may be, for example, bonding devices arranged in an M*N array, specifically, for example, bonding device patterns that are formed at the dielectric layer 214 and that are arranged in the M*N array. The dielectric layer 214 is etched (etched) based on the bonding device patterns arranged in the M*N array by using the dual-damascene process, to form bonding device windows arranged in the M*N array. The bonding device material is electroplated by using the ECP process based on the bonding device windows arranged in the M*N array, to form the bonding devices arranged in the M*N array. The bonding devices arranged in the M*N array are shown in FIG. 14 or FIG. 15. Refer to FIG. 14. The bonding devices arranged in the M*N array include the bonding device 215 and the bonding device 216 that are adjacent to each other, and the bonding device 100 and the bonding device 200 that are adjacent to each other. The bonding device 215 is adjacent to the bonding device 216 in the x-axis direction, and the bonding device 100 is adjacent to the bonding device 200 in the x-axis direction. No channel is disposed between the bonding device 100 and the bonding device 200. Alternatively, refer to FIG. 15. The bonding devices arranged in the M*N array include the bonding device 215 and the bonding device 216 that are adjacent to each other, and the bonding device 100 and the bonding device 200 that are adjacent to each other. The bonding device 215 is adjacent to the bonding device 216 in the x-axis direction, and the bonding device 100 is adjacent to the bonding device 200 in the y-axis direction. The x-axis direction crosses the y-axis direction.

S103: Form a channel at the first dielectric layer.

The channel is located between the bonding device 215 and the bonding device 216, and a dielectric constant of the channel is less than a dielectric constant of a material of the dielectric layer 214.

For example, refer to FIG. 21. To manufacture the channel, chemical mechanical planarization (chemical mechanical planarization, CMP)/chemical mechanical polishing usually further needs to be performed on the dielectric layer 214 and surfaces in the z direction of the plurality of bonding devices that penetrate the dielectric layer 214, so that upper surfaces of the dielectric layer 214 and the bonding devices that penetrate the dielectric layer 214 are flat, and the channel is manufactured. The step of manufacturing the channel specifically includes the following steps.

S1031: Deposit a protective film.

The protective film covers the dielectric layer 214 and the plurality of bonding devices.

For example, refer to FIG. 22. There is a possibility that the photoresist cannot be attached to upper surfaces of the plurality of bonding devices (for example, the bonding device 215 and the bonding device 216). Therefore, the protective film 2201 is usually deposited first. The protective film 2201 covers the dielectric layer 214 and the plurality of bonding devices. The protective film 2201 enables the photoresist to be attached to the upper surfaces of the plurality of bonding devices (for example, the bonding device 215 and the bonding device 216), and the protective film 2201 also prevents a subsequent etching process from damaging structures of the plurality of bonding devices (for example, the bonding device 215 and the bonding device 216). A material of the protective film 2201 includes: the silicon oxide, the silicon nitride, the silicon oxynitride, the nitrogen-doped silicon carbide, and the like. In addition, the material of the protective film 2201 is different from the material of the dielectric layer 214, and has a high wet etching selectivity. In this way, when the protective film 2201 is subsequently etched by using a wet (wet) etching process, damage to the material of the dielectric layer 214 is reduced.

S1032: Form a photoresist covering the protective film.

For example, refer to FIG. 22. After the protective film 2201 is deposited, a photoresist 2202 covering the protective film 2201 is formed. The photoresist 2202 may be a positive photoresist or a negative photoresist.

S1033: Perform photoetching on the photoresist to form a channel pattern.

For example, refer to FIG. 22. The photoresist 2202 is shielded by the light shielding plate, and photoetching is performed on the photoresist 2202, to form the channel pattern 2203 shown in FIG. 22.

S1034: Etch the first dielectric layer based on the channel pattern to form the channel.

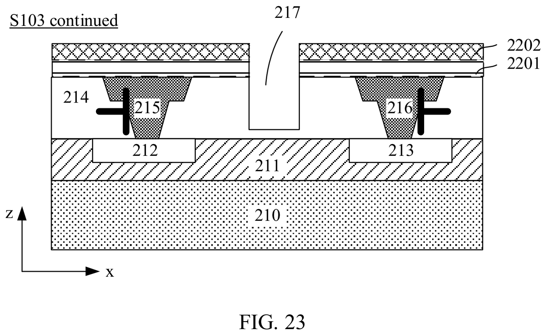

Refer to FIG. 23. The dielectric layer 214 is etched (etched) based on the channel pattern 2203 to form the channel 217. Specifically, a depth of the channel 217 in a z-axis direction may be controlled by controlling etching time, and a width of the channel 217 in the y-axis direction and a length of the channel 217 in the x-axis direction may be controlled by adjusting a size of the light shielding plate. The depth of the channel 217, the width of the channel 217, and the length of the channel 217 are related to performance of the chip 21. This is not limited in this embodiment of this application.

For example, in step S1032, the channel pattern 2203 formed through photoetching is a rectangle, and the channel pattern 2203 is located between the bonding device 215 and the bonding device 216. In step S1033, the channel 217 formed by etching (etching) the dielectric layer 214 based on the channel pattern 2303 is specifically the channel 217 shown in FIG. 7. In some other embodiments, in step S1032, channel patterns 2203 formed through photoetching are a plurality of rectangles, and the channel patterns 2203 are located between the bonding device 215 and the bonding device 216. In step S1033, the channel 217 formed by etching (etching) the dielectric layer 214 based on the channel patterns 2303 specifically includes a plurality of subchannels.

For example, in some embodiments, when the channel 217 is filled with a predetermined material, the predetermined material further needs to be deposited into the channel 217 shown in FIG. 23 by using a deposition process. A node constant of the predetermined material is less than the dielectric constant of the material of the dielectric layer 214, and the predetermined material includes one or more of the following: SiLK, hydrogen silsesquioxane (HSQ), methyl silsesquioxane (MSQ), and nanoglass.

Finally, refer to FIG. 23. The protective film 2201 and the photoresist 2202 further need to be removed through etching by using the wet (wet) etching process, to form the structure of the chip 21 shown in FIG. 7 and FIG. 8.

For example, when the channel 217 is a groove disposed at the dielectric layer 214, and an upper surface of the channel 217 is an opening, the channel 217 has been successfully disposed.

For example, when the channel 217 is a path disposed at the dielectric layer 214, and the channel 217 is completely buried at the dielectric layer 214, another part of the dielectric layer 214 further needs to be subsequently deposited or bonded at the dielectric layer 214, to completely bury the channel 217 at the dielectric layer 214.

For example, in a first embodiment, to form the chip 21 shown in FIG. 9 and FIG. 8, step S103 of forming the channel at the first dielectric layer includes: forming, at the dielectric layer 214 (that is, the first dielectric layer), a first channel surrounding the bonding device 215. The channel 217 includes a part that is of the first channel and that is located between the bonding device 215 and the bonding device 216. Specifically, the protective film covering the dielectric layer 214 and the plurality of bonding devices may be formed, the photoresist covering the protective film is formed, and photoetching is performed on the photoresist to form a first channel pattern surrounding the bonding device 215. The first channel pattern is specifically a rectangular ring, and the first channel pattern surrounds the bonding device 215. The first channel pattern is etched, to form the channel 218 (that is, the first channel) shown in FIG. 9. The channel 217 includes a part that is of the channel 218 that is located between the bonding device 215 and the bonding device 216.

In a second embodiment, to form the chip 21 shown in FIG. 10 and FIG. 8, step S103 of forming the channel at the first dielectric layer includes: forming, at the dielectric layer 214 (that is, the first dielectric layer), a first channel surrounding the bonding device 215. The first channel includes a plurality of spaced subchannels, and the channel 217 includes a part that is of the first channel and that is located between the bonding device 215 and the bonding device 216. Specifically, the protective film covering the dielectric layer 214 and the plurality of bonding devices may be formed, the photoresist covering the protective film is formed, and photoetching is performed on the photoresist to form a first channel pattern surrounding the bonding device 215. The first channel pattern includes a plurality of spaced rectangles, and the plurality of spaced rectangles surround the bonding device 215. The first channel pattern is etched, to form the channel 218 (that is, the first channel) shown in FIG. 10. The channel 218 includes a plurality of spaced subchannels 2180, and the channel 217 is a part of subchannels 2180 that are of the channel 218 and that are located between the bonding device 215 and the bonding device 216.

In a third embodiment, to form the chip 21 shown in FIG. 11 and FIG. 12, step S103 of forming the channel at the first dielectric layer includes: forming, at the dielectric layer 214 (that is, the first dielectric layer), a first channel surrounding the bonding device 215, where the channel 217 includes a part that is of the first channel and that is located between the bonding device 215 and the bonding device 216; and forming, at the dielectric layer 214, a second channel surrounding the bonding device 216, where the channel 217 further includes a part that is of the second channel and that is located between the bonding device 215 and the bonding device 216. Specifically, the protective film covering the dielectric layer 214 and the plurality of bonding devices may be formed, the photoresist covering the protective film is formed, and photoetching is performed on the photoresist to form a first channel pattern surrounding the bonding device 215 and a second channel pattern surrounding the bonding device 216. The first channel pattern is specifically a rectangular ring, and the first channel pattern surrounds the bonding device 215. The second channel pattern is specifically a rectangular ring, and the second channel pattern surrounds the bonding device 216. The first channel pattern and the second channel pattern are etched, to form the channel 218 (that is, the first channel) and the channel 219 (that is, the second channel) shown in FIG. 11. The channel 217 includes a part that is of the channel 218 and that is located between the bonding device 215 and the bonding device 216, and the channel 217 also includes a part that is of the channel 219 and that is located between the bonding device 215 and the bonding device 216.

In a fourth embodiment, to form the chip 21 shown in FIG. 13 and FIG. 12, step S103 of forming the channel at the first dielectric layer includes: forming, at the dielectric layer 214 (that is, the first dielectric layer), a first channel surrounding the bonding device 215, where the first channel includes a plurality of spaced subchannels, and the channel 217 includes a part that is of the first channel and that is between the bonding device 215 and the bonding device 216; and forming, at the dielectric layer 214, a second channel surrounding the second bonding device, where the second channel includes a plurality of spaced subchannels, and the channel 217 further includes a part that is of the second channel and that is located between the bonding device 215 and the bonding device 216. Specifically, the protective film covering the dielectric layer 214 and the plurality of bonding devices may be formed, the photoresist covering the protective film is formed, and photoetching is performed on the photoresist to form a first channel pattern surrounding the bonding device 215 and a second channel pattern surrounding the bonding device 216. The first channel pattern includes a plurality of spaced rectangles, and the plurality of spaced rectangles surround the bonding device 215. The second channel pattern includes a plurality of spaced rectangles, and the plurality of spaced rectangles surround the bonding device 216. The first channel pattern and the second channel pattern are etched, to form the channel 218 (that is, the first channel) and the channel 219 (that is, the second channel) shown in FIG. 13. The channel 218 includes a plurality of spaced subchannels 2180, and the channel 217 is a part of subchannels 2180 that are of the channel 218 and that are located between the bonding device 215 and the bonding device 216. The channel 219 includes a plurality of spaced subchannels 2190, and the channel 217 includes a part of subchannels 2190 that are of the channel 219 and that are located between the bonding device 215 and the bonding device 216.

For example, an embodiment of this application further provides a manufacturing method for the chip stacked structure 20. Specifically, the manufacturing method for the chip stacked structure 20 includes:
forming the chip 21a, where the chip 21a may be the chip 21 shown in any one of FIG. 7 to FIG. 15, for example, the chip 21a may be manufactured by performing the foregoing manufacturing method for a chip, and the chip 21a is a first chip in the chip stacked structure 20;
forming the chip 21b, where the chip 21b may be the chip 21 shown in any one of FIG. 7 to FIG. 15, for example, the chip 21b may be manufactured by performing the foregoing manufacturing method for a chip, and the chip 21b is a second chip in the chip stacked structure 20; and
bonding the chip 21a with the chip 21b to form the chip stacked structure shown in FIG. 16. The bonding device 215a is electrically connected to the bonding device 215b, the bonding device 216a is electrically connected to the bonding device 216b, and the channel 217a is aligned with the channel 217b. The dielectric layer 214a is fused with the dielectric layer 214b, or the dielectric layer 214a is in contact with the dielectric layer 214b. For example, a layout of the dielectric layer 214a of the chip 21a is the same as a layout of the dielectric layer 214b of the chip 21b. For example, if the layout of the dielectric layer 214a of the chip 21a is a layout of the dielectric layer 214 of the chip 21 shown in FIG. 7, the layout of the dielectric layer 214b of the chip 21b is also the layout of the dielectric layer 214 of the chip 21 shown in FIG. 7. Alternatively, in some other embodiments, a layout of the dielectric layer 214a of the chip 21a is different from a layout of the dielectric layer 214b of the chip 21b. The layout of the dielectric layer 214a of the chip 21a and the layout of the dielectric layer 214b of the chip 21b are not limited in this embodiment of this application.

In some embodiments, when the channel 217a of the chip 21a is a groove disposed at the dielectric layer 214a, an upper surface of the channel 217a is an opening, and the channel 217a is not filled with an actual material, and when the channel 217b of the chip 21b is a groove disposed at the dielectric layer 214b, an upper surface of the channel 217b is an opening, and the channel 217b is not filled with an actual material, the chip 21a is bonded with the chip 21b, and the channel 217a is aligned with the channel 217b to form an aligned structure. When the chip stacked structure 20 is manufactured in an air environment, the aligned structure is filled with air. When the chip stacked structure 20 is manufactured in an inert gas environment, the aligned structure is filled with an inert gas. When the chip stacked structure 20 is manufactured in a vacuum environment, an inner part of the aligned structure is of a vacuum environment.

Although this application is described with reference to specific features and embodiments thereof, it is clearly that various modifications and combinations may be made to them without departing from the spirit and scope of this application. Correspondingly, the specification and accompanying drawings are merely example description of this application defined by the appended claims, and are considered as any of and all modifications, variations, combinations or equivalents that cover the scope of this application. It is clearly that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. A chip, comprising:
a die; and
a first dielectric layer disposed on a side of the die, and a plurality of bonding devices that penetrate the first dielectric layer, wherein the plurality of bonding devices comprise a first bonding device and a second bonding device that are adjacent to each other, a channel between the first bonding device and the second bonding device is formed at the first dielectric layer, and a dielectric constant of the channel is less than a dielectric constant of a material of the first dielectric layer.

2. The chip according to claim 1, wherein
the channel is filled with air or an inert gas; or
the channel is of a vacuum environment; or
the channel is filled with a predetermined material, and a dielectric constant of the predetermined material is less than the dielectric constant of the material of the first dielectric layer.

3. The chip according to claim 1 or 2, wherein
a first channel surrounding the first bonding device is formed at the first dielectric layer, and the channel comprises a part that is of the first channel and that is located between the first bonding device and the second bonding device.

4. The chip according to any one of claims 1 to 3, wherein
a second channel surrounding the second bonding device is formed at the first dielectric layer, and the channel comprises a part that is of the second channel and that is located between the first bonding device and the second bonding device.

5. The chip according to any one of claims 1 to 4, wherein
the plurality of bonding devices further comprise a third bonding device and a fourth bonding device that are adjacent to each other.

6. The chip according to any one of claims 1 to 5, wherein
a second dielectric layer is further disposed between the die and the first dielectric layer, a first metal routing is disposed at the second dielectric layer, the first metal routing is electrically connected to the first bonding device, and the first metal routing is electrically connected to the second bonding device.

7. The chip according to any one of claims 1 to 5, wherein
a second dielectric layer is further disposed between the die and the first dielectric layer, a first metal routing and a second metal routing are disposed at the second dielectric layer, the first metal routing is electrically connected to the first bonding device, and the second metal routing is electrically connected to the second bonding device.

8. The chip according to any one of claims 1 to 7, wherein
the material of the first dielectric layer comprises one or more of the following: silicon oxide, silicon nitride, silicon oxynitride, and nitrogen-doped silicon carbide.

9. The chip according to any one of claims 1 to 8, wherein materials of the plurality of bonding devices comprise one or more of the following: copper and tungsten.

10. A chip stacked structure, wherein the chip stacked structure comprises a plurality of stacked chips, and the plurality of stacked chips comprise the chip according to any one of claims 1 to 9.

11. The chip stacked structure according to claim 10, wherein the plurality of stacked chips comprise a first chip and a second chip, the first chip comprises the chip according to any one of claims 1 to 9, and the second chip comprises the chip according to any one of claims 1 to 9; and
a first bonding device of the first chip is electrically connected to a first bonding device of the second chip, a second bonding device of the first chip is electrically connected to a second bonding device of the second chip, and a channel of the first chip is aligned with a channel of the second chip.

12. A chip package structure, comprising a package substrate and the chip stacked structure according to claim 10 or 11, wherein the chip stacked structure is electrically connected to the package substrate.

13. An electronic device, comprising a printed circuit board and the chip package structure according to claim 12, wherein a package substrate in the chip package structure is electrically connected to the printed circuit board.

14. A manufacturing method for a chip, comprising:
forming a first dielectric layer on a side of a die;
forming, at the first dielectric layer, a plurality of bonding devices that penetrate the first dielectric layer, wherein the plurality of bonding devices comprise a first bonding device and a second bonding device that are adjacent to each other; and
forming a channel at the first dielectric layer, wherein the channel is located between the first bonding device and the second bonding device, and a dielectric constant of the channel is less than a dielectric constant of a material of the first dielectric layer.

15. The manufacturing method for a chip according to claim 14, wherein
the channel is filled with air or an inert gas; or
the channel is of a vacuum environment; or
the channel is filled with a predetermined material, and a dielectric constant of the predetermined material is less than the dielectric constant of the material of the first dielectric layer.

16. The manufacturing method for a chip according to claim 14 or 15, wherein forming the channel at the first dielectric layer comprises:
forming a first channel surrounding the first bonding device at the first dielectric layer, wherein the channel comprises a part that is of the first channel and that is located between the first bonding device and the second bonding device.

17. The manufacturing method for a chip according to any one of claims 14 to 16, wherein
forming the channel at the first dielectric layer comprises:
forming a second channel surrounding the second bonding device at the first dielectric layer, wherein the channel comprises a part that is of the second channel and that is located between the first bonding device and the second bonding device.

18. The manufacturing method for a chip according to claim 14 or 15, wherein
forming the channel at the first dielectric layer comprises:
depositing a protective film, wherein the protective film covers the first dielectric layer and the plurality of bonding devices;
forming a photoresist covering the protective film;
performing photoetching on the photoresist to form a channel pattern; and
etching the first dielectric layer based on the channel pattern to form the channel.

19. The manufacturing method for a chip according to any one of claims 14 to 18, wherein
before forming the first dielectric layer on the side of the die, the method further comprises:
forming a second dielectric layer on the side of the die, wherein the second dielectric layer is located between the die and the first dielectric layer; and
forming a first metal routing at the second dielectric layer, wherein the first metal routing is electrically connected to the first bonding device, and the first metal routing is electrically connected to the second bonding device.

20. The manufacturing method for a chip according to any one of claims 14 to 19, wherein
before forming the first dielectric layer on the side of the die, the method further comprises:
forming the second dielectric layer on the side of the die, wherein the second dielectric layer is located between the die and the first dielectric layer; and
forming the first metal routing and a second metal routing at the second dielectric layer, wherein the first metal routing is electrically connected to the first bonding device, and the second metal routing is electrically connected to the second bonding device.

21. A manufacturing method for a chip stacked structure, comprising:
forming a first chip, wherein the first chip comprises the chip according to any one of claims 1 to 9;
forming a second chip, wherein the second chip comprises the chip according to any one of claims 1 to 9; and
bonding the first chip with the second chip, wherein a first bonding device of the first chip is electrically connected to a first bonding device of the second chip, a second bonding device of the first chip is electrically connected to a second bonding device of the second chip, and a channel of the first chip is aligned with a channel of the second chip.
